# EUROPÄISCHE PATENTANMELDUNG

(11) **EP 1 681 366 A1**
(43) Veröffentlichungstag der Anmeldung: **19.07.2006**
(21) Anmeldenummer: 06003526.8
(22) Anmeldetag: 09.10.2003
(51) Int. Cl.: C23C 4/00, C23C 8/04, C23C 10/04, C23C 14/04, C23C 16/04, B05B 15/04

(54) **Verfahren zur Beschichtung eines Bauteils und Bauteil**

(62) Teilanmeldung aus: 03022909.0
(71) Anmelder: SIEMENS AKTIENGESELLSCHAFT, 80333 München (DE)
(72) Erfinder: Dernovsek, Oliver, Dr., 8054 Graz (AT); Reiche, Ralph, 13465 Berlin (DE)

(57) **Zusammenfassung**

Maskierungsschichten für Bauteile nach dem Stand der Technik reagieren mit dem Grundmaterial des Bauteils bzw. lassen sich schlecht wieder entfernen.

Das erfindungsgemäße Bauteil weist eine Maskierungsschicht (7) auf, die sich nach einer Beschichtung des Bauteils (1) sehr leicht entfernen lässt.
Die Maskierung (7) besteht aus einer ersten Schicht (34), die auf der Oberfläche des Bauteils (1) aufliegt, und zumindest einer zweiten, äußersten Schicht (37), die auf der ersten Schicht (34) vorhanden ist,
wobei die zweite, äußerste Schicht (37) kleinere Poren, insbesondere eine geringere Porosität, aufweist als die erste Schicht (34),
wobei die erste Schicht (34) und die zweite Schicht (37) zumindest teilweise aus Pulver bestehen und
unterschiedliche Korngrößenverteilungen aufweisen,
wobei das Material der ersten Schicht (34) und/oder der zweiten Schicht (37) und/oder das Füllmaterial (40) zumindest teilweise aus Keramik und einem Kohlenstoff-Precursor besteht,
wobei das Material der ersten Schicht (34) und/oder der zweiten Schicht (37) und/oder das Füllmaterial (40) aus einem Kohlenstoff/Metallgemisch und einem Kohlenstoff-Precursor besteht,
wobei die zweite, äußerste Schicht (37) eine geringere Porosität aufweist als die erste Schicht (34).

## Beschreibung

Die Erfindung betrifft ein Verfahren zur Beschichtung eines Bauteils gemäß dem Gattungsbegriff des Anspruchs 1 und ein Bauteil gemäß dem Gattungsbegriff des Anspruchs 15.

Bei der Beschichtung von Bauteilen soll nicht immer die gesamte äußere oder innere Oberfläche eines Bauteils beschichtet werden. Dies gilt für sämtliche Beschichtungsverfahren, wie z.B. Plasmaspritzen, PVD- (physical vapour deposition) oder CVD- (chemical vapour deposition) Prozesse.

Teile der Beschichtung müssen dort entfernt werden, in denen keine Beschichtung erwünscht war. Dies muss oft durch eine abrasive Abtragung der Beschichtung in diesen Bereichen geschehen, da das Material der Beschichtung sehr gut auf dem Bauteil haftet oder sogar mit diesem reagiert, wenn z.B. das Bauteil mit Aluminium beschichtet wurde, um eine Alitierung durchzuführen.
Die abrasive Abtragung führt jedoch häufig in gewissem Maße zu einer Schädigung oder Geometrieveränderung des Bauteils. Dies ist z.B. beim Sandstrahlen der Fall, bei dem die Sandpartikel beispielsweise Teile einer Aluminium-Beschichtung von dem Bauteil wieder entfernen.

Die JP 19810191826 offenbart eine poröse Schicht aus Aluminiumoxid, in die eine metallische Schicht infiltriert wird. Die metallische Schicht entsteht durch Umschmelzen.

Die US 5,725,905 offenbart eine Schicht aus einer Keramik, auf die eine metallische Schicht in Form eines Presslings aufgelegt wird, die anschließend gesintert wird.

Die US-PS 6,036,995 zeigt die Notwendigkeit von Maskierungen durch Klebebänder, Metallfolien zur Abdeckung nicht zu beschichtender Oberflächenbereiche. Die Beschichtung erfolgt durch Auftrag von Schlicker. Metallfolien haften nicht gut auf Unterlagen und bieten daher, z.B. in einer Bedampfungsanlage, in der die aufzutragenden Teilchen sich in allen Richtungen bewegen, nur unzureichenden Schutz (Unterwanderung der Folie) .
Klebebänder halten keine hohen Temperaturen aus.

Bei der US-PS 5,985,368 erfolgt eine Beschichtung durch einen Schlicker aus Keramik. Es findet keine Maskierung statt.

Die US-PS 6,283,714 zeigt die Notwendigkeit von Maskierungen bei Beschichtungen mit Aluminium. Durch eine bestimmte Anordnung innerhalb der Beschichtungsanlage wird aber vermieden, dass sich Aluminium auf den ungewünschten Stellen abscheidet.

Die GB 2 210 387 A beschreibt, dass eine Maskierung durch einen Schlicker oder Paste aufgetragen wird, wobei ein Binder enthalten ist.

Die JP 11 181 561 offenbart eine Maskierung, wobei die Maskierung aus einen organischem Lösungsmittel, einem organischen Binder und einem Pulver besteht.
Dies ist eine allgemeine Vorgehensweise. Pulver mit Binder in einem Trägermittel wird auf ein Bauteil aufgebracht.
Der Binder hält das Pulver zusammen, wird nach dem Auftragen und Verdampfen des Trägermittels ausgebrannt und das Pulver wird versintert, damit es stabil bleibt

Es ist daher Aufgabe der Erfindung ein Verfahren zur Beschichtung eines Bauteils aufzuzeigen, bei dem durch eine Maskierung eine spätere Beschichtung des Bauteils in den unerwünschten Bereichen unterbleibt, wobei die Maskierung auf einfache Art und Weise nach Durchführung der Beschichtung wieder entfernt werden kann.

Die Aufgabe wird durch ein Verfahren gemäß Anspruch 1 gelöst.

Es ist außerdem Aufgabe der Erfindung ein Bauteil aufzuzeigen, bei dem durch eine Maskierung eine Beschichtung in den unerwünschten Bereichen unterbleibt, wobei die Maskierung später von dem beschichteten Bauteil auf einfache Art und Weise wieder entfernt werden kann.

Die Aufgabe wird durch ein Bauteil gemäß Anspruch 15 gelöst. Dabei weist das Bauteil eine Maskierung aus mehreren Schichten auf, die nur aus Pulver bestehen.

In den Unteransprüchen sind weitere vorteilhafte Verbesserungen des Verfahrens gemäß Anspruch 1 und des Bauteils gemäß Anspruch 15 aufgelistet.
Die in den Unteransprüchen aufgelisteten Maßnahmen können in vorteilhafter Art und Weise miteinander kombiniert werden.

Ausführungsbeispiele sind in den nachfolgenden Figuren erläutert.

Es zeigen
- Figuren 1, 2, 3: Verfahrensschritte des erfindungsgemäßen Verfahrens,
- Figur 4, 5: Anwendungsbeispiele des Verfahrens,
- Figur 6: ein erfindungsgemäßes Bauteil,
- Figur 7: eine Turbinenschaufel,
- Figur 8: eine Brennkammer,
- Figur 9: eine Gasturbine.

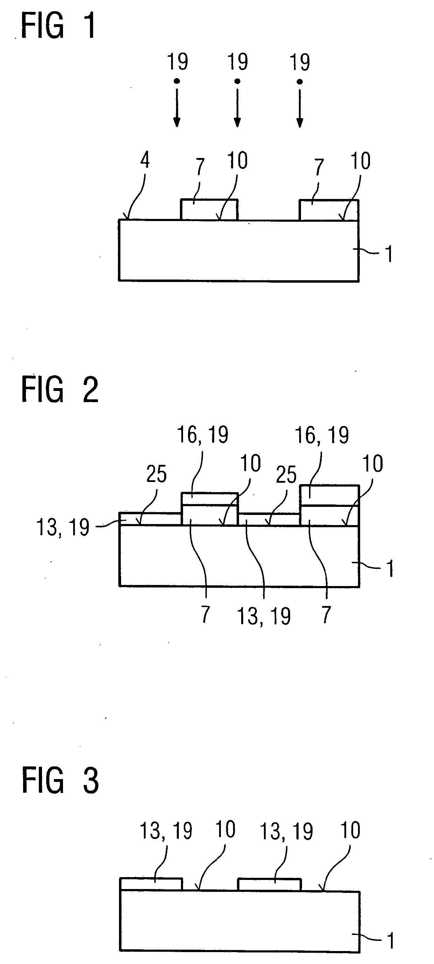

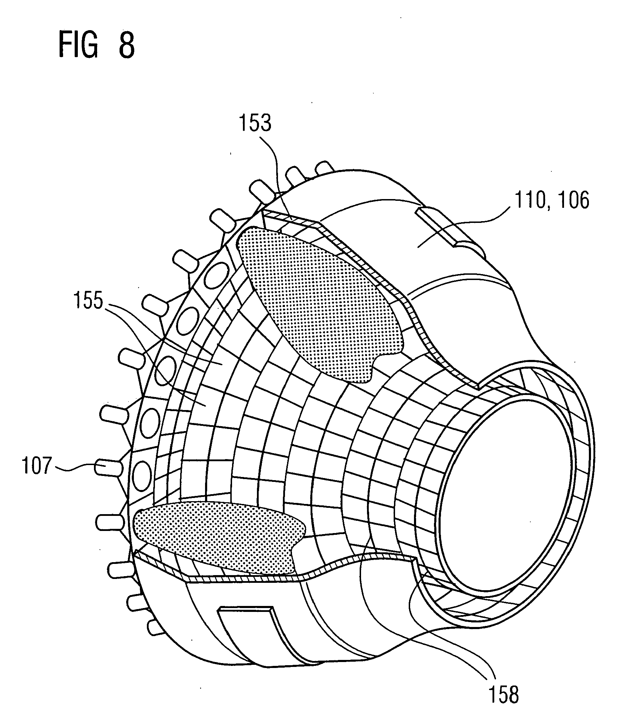

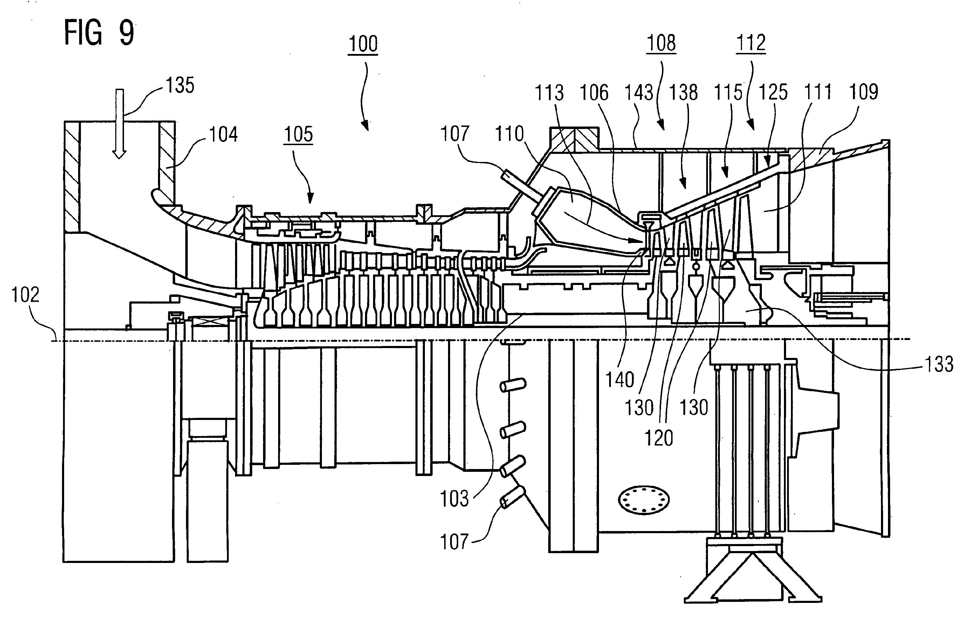

Figur 1 zeigt ein Bauteil 1, insbesondere eine Turbinenschaufel 120, 130 (Fig. 9), Brennkammerteil 153, 155 (Fig. 8) oder ein Gehäuseteil einer Dampf- oder Gasturbine 100 (bspw. auch Flugzeugturbine), beispielsweise bestehend aus einer eisen-, nickel- oder kobalt- basierten Superlegierung, das eine Oberfläche 4 aufweist.

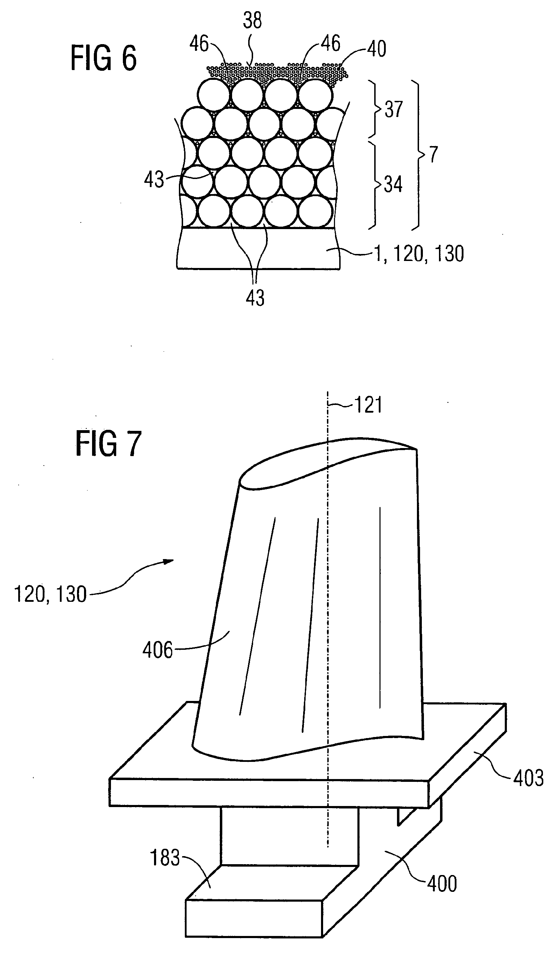

Die Oberfläche 4 des Bauteils 1 soll mit einem keramischen oder metallischen Beschichtungsmaterial 19, wie z.B. Aluminium (Al), beschichtet werden, wobei die Beschichtung (13) insbesondere aus einer Dampfphase aufgebracht wird.
Dabei gibt es Bereiche 10, in denen die Beschichtung 13 mit dem Beschichtungsmaterial 19 nicht erwünscht ist, wie z.B. ein Schaufelfuß 183 (Fig. 7) einer Turbinenschaufel 120, 130.

Diese Bereiche 10 werden durch eine Maskierung 7 geschützt, die auf dem Bauteil 1, 120, 130, 153, 155 ausgebildet ist und deren Aufbau in Zusammenhang mit Figur 6 weiter unten noch näher erläutert wird. Die Maskierung 7 besteht bspw. aus einem oder mehreren Pulvern.
Dabei muss das Pulver auf die Oberfläche 4 des Bauteils 1 aufgebracht werden.
Die Maskierung 7 wird beispielsweise in Form einer Suspension, eines Schlickers oder einer Paste auf die Bereiche 10 aufgebracht.
Die Maskierung 7 bleibt während der Beschichtung des Bauteils 1, 120, 130, 153, 155 auf dem Bauteil 1, 120, 130, 153, 155 haften.

Die Suspension besteht beispielsweise aus einem flüssigen Trägermittel, einem Binder (anorganisch oder organisch), der sich im Trägermittel löst, und dem Pulver oder Pulvergemisch. Als Trägermittel eignen sich beispielsweise Alkohole und Wasser. Dabei wird vorteilhaft 30wt% bis 50wt%, insbesondere 40wt% Trägermittel und 50wt% bis 70wt%, insbesondere 60wt% Pulver verwendet.
Die Suspension wird durch Rühren oder sonstige Anregung während des Auftragungsprozesses der Maskierung 7 ständig durch sehr hohen kinetischen Eintrag, insbesondere durch einen Dissolver, durchmischt, so dass sich das Pulver in der Suspension nicht absetzt und/oder Agglomerate von Pulverkörnern aufgebrochen werden und sich keine neuen Agglomerate bilden.

Gegebenenfalls können Stabilisatoren in dem Trägermittel enthalten sein, die aber mit dem Trägermittel nach dem Auftrag der Suspension sich verflüchtigen oder verdampfen.

Die Maskierung 7 kann auch durch Eintauchen des Bauteils 1, 120, 130, 153, 155 in die Suspension, Bepinseln, Aufsprühen oder sonstige Auftragungsarten auf das Bauteil 1, 120, 130, 153, 155 in den Bereichen 10 aufgebracht werden.
Insbesondere eignet sich das Aufpinseln der Suspension.

Die Auftragung kann lokal eng begrenzt oder auch großflächig erfolgen.
Da die Auftragung bei Raumtemperatur erfolgt, können die anderen Bereiche 25, also die, bei denen später eine Beschichtung 13 erfolgen soll, beispielsweise durch Klebeband abgedeckt werden, welches sich einfach und ohne Rückstände entfernen lässt.

Nach der Auftragung verflüchtigt sich das Trägermittel oder verdampft. Dazu kann die Maskierung 7 leicht erwärmt werden.

Die Maskierung 7 sollte eine derart geschlossene Oberfläche bilden, dass kein Material 19, insbesondere Metall- oder Keramikdampf, bei einer folgenden Beschichtung durch die Maskierung 7 bis zu der Oberfläche 4 in den Bereichen 10 hindurchdringen kann.

Das Pulver der Maskierung 7 kann so ausgewählt werden, dass das Material 19 der später folgenden Beschichtung 13 an dem Pulver aufgrund dessen Oberflächeneigenschaften (Rauhigkeit, ...) abperlt, so dass kein Material 19 der folgenden Beschichtung 13 durch die Maskierung 7 hindurchdringen kann.

Die Beschichtung des Bauteils 1, 120, 130, 153, 155 bestehend aus dem Beschichtungsmaterial 19 wird beispielsweise aufgedampft und erfolgt beispielsweise durch einen CVD-Prozess (Chemical vapour deposition) oder PVD-Prozess (physical vapour deposition) oder Plasmaspritzen.

Dabei herrschen Temperaturen von bis zu 1200°C (Beschichtungstemperatur).
Weitere Beschichtungsarten sind denkbar.
Ebenso können zwei Schichten auf die Bereiche 25 und damit auf die Maskierung aufgebracht werden, beispielsweise wird eine metallische Zwischenschicht (MCrAlX) und darauf eine keramische Schicht (Wärmedämmschicht) aufgebracht.

Figur 2 zeigt das maskierte Bauteil 1, das bereits beschichtet worden ist.
Es gibt Bereiche 25 auf der Oberfläche 4 mit einer Beschichtung 13 auf dem Bauteil 1, wo diese erwünscht ist. Ebenso gibt es eine Beschichtung 16 auf der Maskierung 7.

Da die Maskierung 7 einfach entfernt werden kann, weil sie nur leicht bspw. durch Verklammerung und/oder Adhäsion an dem Bauteil 1 haftet, kommt es in den Bereichen 10, in denen keine Beschichtung erwünscht war, auch zu keiner Beeinträchtigung des Bauteils 1, 120, 130, 153, 155 an der Oberfläche 4 (Fig. 3).

Die Maskierung 7 kann beispielsweise durch Abwaschen, Trockeneisstrahlen, Abklopfen entfernt werden.
Ebenso kann ein Hochdruckwasserstrahl (bis 330 bar) verwendet werden, wobei der Wasserstrahl 31 beispielsweise so aufgeweitet ist, dass er aus einer Düse 34 großflächig auf die zu entfernende, insbesondere auf die gesamte Maskierung 7 (beispielsweise Schaufelblatt 406) auftrifft und der Strahl nicht gezielt über die zu entfernende Maskierung 7 geführt werden muss.
Dazu ist der Wasserstrahl 31 entsprechend aufgeweitet.
Er erfasst beispielsweise eine vollständige Seite der äußeren Schaufelblattfläche 406 einer Turbinenschaufel 120, 130.

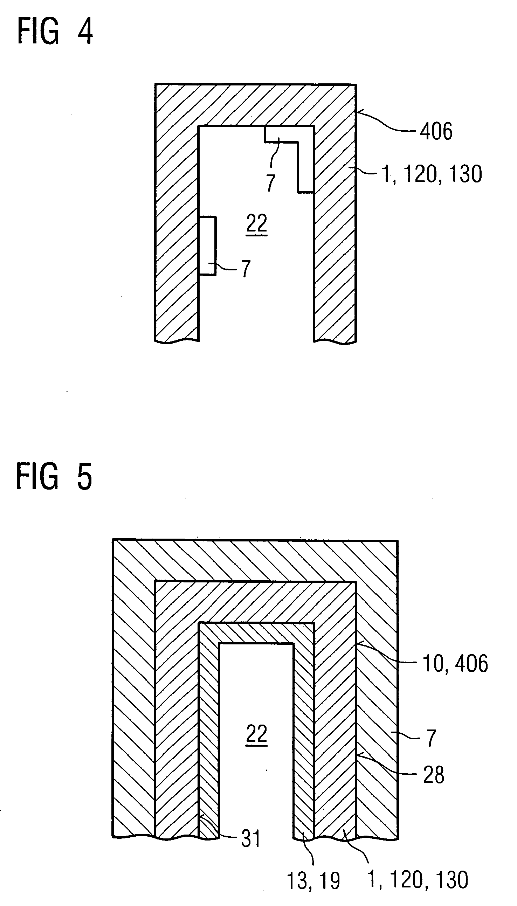

Figur 4 zeigt ein weiteres Anwendungsbeispiel für das erfindungsgemäße Verfahren.

Das Bauteil 1, 120, 130, 153, 155 (Fig. 8, 9) kann auch einen Hohlraum 22 aufweisen, in dem eine Maskierung 7 aufgebracht wird. Das Verfahren eignet sich also nicht nur für außenliegende sondern auch für innenliegende Flächen.

Figur 5 zeigt ein weiteres Anwendungsbeispiel für das erfindungsgemäße Verfahren.
Bei dem Bauteil 1, 120, 130, 153, 155 (Fig. 8, 9) soll eine Beschichtung 13 im Hohlraum 22 des Bauteils 1, 120, 130, 153, 155 erfolgen.
Eine Beschichtung einer äußeren Oberfläche 28, 406 (Fig. 7) des Bauteils 1, 120, 130, 153, 155 ist in diesem Fall nicht erwünscht, so dass eine Maskierung 7 auf die außenliegende Fläche 28, 406 des Bauteils 1, 120, 130, 153, 155 aufgebracht wird.
So kann das ganze Bauteil 1, 120, 130, 153, 155 mit der Maskierung 7 in eine Beschichtungskammer eingeführt werden ohne dass eine Beschichtung 13 in dem Bereich 10, 406 erfolgt, in dem keine Beschichtung erwünscht ist, sondern nur in den gewünschten Bereichen 25 auf einer Innenfläche 31 des Bauteils 1, 120, 130, 153, 155.
Bei Bedarf kann die Innenfläche 31 aber auch an bestimmten gewünschten Stellen durch eine Maskierung 7 geschützt werden. Dies ist bei der Innenalitierung von Turbinenschaufeln für eine Gasturbine besonders sinnvoll.
Die Beschichtungstemperatur liegt dabei bei etwa 1080°C und das Beschichten erfolgt beispielsweise in Inertgas- insbesondere Wasserstoffatmosphäre.

Das Verfahren bzw. eine solche Maskierung 7 kann bei neu hergestellten Bauteilen und/oder wieder aufzuarbeitenden Bauteilen verwendet werden.

Wiederaufarbeitung (Refurbishment) bedeutet, dass neu hergestellte Bauteile, die Fehler aufweisen oder Bauteile, die im Einsatz waren, auf Fehler untersucht werden, wie z.B. Risse, die dann aufgefüllt werden. Bei Bauteilen 1, 120, 130, 153, 155 die im Einsatz waren, werden noch Korrosionsprodukte entfernt. Damit kann ein solches Bauteil 1, 120, 130, 153, 155 wieder verwendet werden, wobei zuvor noch metallische und/oder keramische Schutzschichten aufgebracht werden müssen. Dabei wird die Maskierung 7 gemäß dieser Anmeldung verwendet.

Figur 6 zeigt einen detaillierten Aufbau einer Maskierung 7. Die Maskierung 7 besteht aus einer zumindest doppellagigen Pulverschicht 34, 37.
Die erste Pulverschicht 34 liegt direkt auf der Oberfläche 4 des Bauteils 1 auf.
Die Pulverteilchen der ersten Schicht 34 weisen eine erste mittlere Korngrößenverteilung d1 auf.
Auf der ersten Schicht 34 ist eine zweite, äußerste Schicht 37 aufgebracht, die auf jeden Fall eine freie, äußere Oberfläche 38 bildet.
Die zweite, äußerste Schicht 37 weist beispielsweise die gleichen Pulverteilchen wie die erste Schicht 34 auf, also die gleiche oder zumindest eine vergleichbare mittlere Korngrößenverteilung d2.
Jedoch ist die zweite Schicht 37 bspw. mit einem Füllmaterial 40 aufgefüllt.
Das Füllmaterial 40 besteht beispielsweise aus demselben Material wie die erste Schicht 34 oder zweite Schicht 37. Das Füllmaterial 40 weist jedoch eine mittlere Korngrößenverteilung d3 auf, die unterschiedlich, bspw. kleiner ist als die Korngrößenverteilung d2 der zweiten Schicht 37, so dass sich die Poren der Pulverschicht 37 mit dem Füllmaterial 40 füllen lassen, und die Porosität und Gasdurchlässigkeit der Pulverschicht 37 gegenüber der Pulverschicht 34 sich verringert.

Zur Herstellung einer solchen Maskierung 7 wird eine Schicht aus einem Pulver mit der mittleren Korngrößenverteilung d1 aufgebracht und beispielsweise mit dem Füllmaterial 40 getränkt, das im äußeren Bereich dieser Schicht eindringt und so die zweite Schicht 37 bildet. Das Füllmaterial 40 sollte nicht bis zur Oberfläche 4 des Bauteils 1 vordringen.
Das Pulver des Füllmaterials 40 weist z.B. Durchmesser im Bereich 50...100*µ*m auf und hat einen Anteil von 20 bis 80 vol%, insbesondere von 50 bis 80 vol% in einem Gemisch Füllmaterial 40 und Binder (Kohlenstoff-Precursor).

Andererseits kann die zweite äußerste Schicht 37 also von vornherein auch eine kleinere mittlere Korngrößenverteilung d2 aufweisen als die erste Schicht 34, so dass die Poren 46 und/oder die Porosität der äußersten Schicht 37 kleiner ist als die Poren 43 der ersten Schicht 34.

Somit kann eine im Hinblick auf einen späteren Beschichtungsprozess weitgehend gasdichte äußerste Schicht 37 erzeugt werden. Die Gasdichtheit kann alternativ auch erst nach einer Sinterung und/oder Wärmebehandlung und/oder Aufschmelzung der äußersten Schicht 37 erreicht werden.

Die Pulver der Schichten 34, 37 bestehen bspw. aus einem Gemisch eines Kohlenstoff-Precursors und Kohlenstoff, insbesondere Graphit und/oder Keramik und/oder Metall.
Anstatt Graphit kann auch eine Mischung aus Metall und Graphit verwendet werden.
Dabei wird bspw. ein Binder (bspw. Novolak) hinzugefügt, der in dem Trägermittel löslich ist und sich aufgrund seiner organischen Bestandteile bei einer Wärmebehandlung in einen Kohlenstoff-Precursor umwandelt.

Bspw. durch gezielte Wiederholung des Auftragungsverfahrens für die Maskierung sind Schichtdicken für die Maskierung 7 im Bereich 200...2000µm erreichbar.

Bevor das Bauteil 1 später beschichtet werden soll, findet beispielsweise eine Wärmebehandlung des Bauteils 1 mit der Maskierung 7 im Bereich 150...250°C statt, die infolge der thermischen Vernetzung des Kohlenstoff-Precursors zu einer Verfestigung der ersten und zweiten Schicht 34, 37 führt. Es bildet sich z.B. ein Kunststoff-Polymer.
So wird sowohl die Haftung zur Oberfläche 4 eingestellt als auch eine gute äußere Schichtqualität in Form einer rissfreien Kunststoffschicht (im Grünzustand, d.h. vernetzt) gewährleistet.

Unter Inertgasbedingungen (Ar, N) des späteren Beschichtungsprozess bei Temperaturen von z.B. bis zu 1200°C wird der Kunststoff in einen amorphen Zustand überführt und dann graphitisiert (kristallisiert). Dabei bilden sich nanometergroße Kohlenstoffteilchen, die aufgrund ihrer hohen spezifischen Oberflächen sehr reaktiv sind.
Bei 700-900°C findet eine Versinterung statt, die die Maskierung 7 mechanisch stabilisiert.

Das Mehrschichtsystem wird beispielsweise durch die Verwendung eines graphitgefüllten Novolaks realisiert, mit der eine Beschichtungspaste hergestellt wird, welche bei der Zersetzung in der reaktiven AI-Heißgasphase turbostratischen, hochreaktiven Kohlenstoff im nm-Bereich ausbildet. Die Partikel im Nanometer-Bereich führen zu einer kinetisch beschleunigten Carbidbildung. Dadurch wird der Aufbau einer dichten Diffusionssperre bereits bei geringen Temperaturen ausgebildet bevor die maximale Beschichtungstemperatur erreicht wird. Die porösere erste Schicht 34 bewirkt, dass die thermischen Eigenspannungen des Systems aus Bauteil 1 und Beschichtungen 34, 37 der Maskierung 7 minimiert werden.

Vorzugsweise erfolgt die Materialauswahl so, dass das Beschichtungsmaterial 19 mit dem Material der zweiten Schicht 37 während der späteren Beschichtung zu einem leicht entfernbaren, insbesondere wasserlöslichen Produkt, insbesondere einem Karbid reagiert.
Die zweite Schicht 37 besitzt eine gasdichte Oberfläche durch die Einbringung feinster Partikel (Füllmaterial 40) mit einer hohen spezifischen Oberfläche und damit einer erhöhten Reaktivität gegenüber einem Metallgas, bspw. der Al-Gasphase.

Dadurch kommt es zur Ausbildung einer dichten Al₄C₃ Schicht, die als Diffusionsbarriere gegenüber nachströmendem A1-Gas wirkt.

Beispiel für die Zusammensetzung der Schichten 34, 37:
Schicht 34: (Dicke < 500µm) Graphit 80vol% mit d1₅₀ 100*µ*m und 20vol% Novolak;
Schicht 37: (Dicke > 1 mm) Graphit 10vol% mit d2₅₀ = 100 *µ*m + 20vol% mit d2₅₀ = 15 *µ*m + 20vol% mit d2₅₀= 1..3 *µ*m und 50vol% Novolak;
   oder
Schicht 37: (Dicke > 1 mm) Graphit 10vol% mit d2₅₀ = 100µm + 10vol% mit d2₅₀ = 15*µ*m + 30vol% mit d2₅₀= 1..3µm und 50vol% Novolak;
alternativ jeweils
Schicht 34: Graphit 40vol% mit d1₅₀ = 100µm + Metall (bestehend aus Co, Ni, Al) 40vol% mit d1₅₀ = 22*µ*m und Novolak 20vol%.

Die Korngrößenverteilungen der Pulver für die Schichten 34, 37 können also aus mehreren Pulverchargen eingestellt werden, die jeweils eine charakteristische Korngrößenverteilung aufweisen. Mehrere Korngrößenverteilungen führen im Pulvergemisch jeweils zu einer gewünschten Korngrößenverteilung d1 oder d2.
Die größere Porosität der Schicht 34 ermöglicht auch nach der späteren Beschichtung 13 eine gute Ablösung von dem Bauteil 1.

Die Vorteile der erfindungsgemäßen Maskierung 7 sind
- hohe Reinheit der Ausgangsstoffe für die Pulver der Schichten 34, 37 und des Füllmaterials 40 (keine zusätzlichen Verunreinigungen, hohe Prozesssicherheit) gewährleistbar;
- kommerzielle Verfügbarkeit (reduzierter Materialpreis, Reproduzierbarkeit des Prozesses durch die Verwendung bekannter Rohstoffe, Know-how Transfer in die Fertigung ist dadurch vereinfacht);
- Polymer (Binder) erlaubt die Verwendung etablierter Prozesse aus der Kunststoff-Industrie (Lacke, Spritzguss, Vernetzung);
- Dispergierprozesse erlauben eine sehr gute Homogenisierung der aufgefüllten Schicht 37 (Reproduzierbarkeit des Prozesses) ;
- der Kohlenstoff-Precursor wird bei der Graphitisierung vom amorphen bis zum turbostratischen Kohlenstoff umgewandelt; während des Umwandlungsprozesses entsteht dabei hochdisperser und hochreaktiver Nanometer-Kohlenstoff, so dass gasförmiges Aluminium bei reduzierten Prozesstemperaturen < 700°C°C zu Al₄C₃ karburiert; neben der raschen Ausbildung der Diffusionsschutzschicht werden auch die thermischen Eigenspannungen im Schichtsystem dadurch deutlich verringert;
- Bildung von Kohlenstoff wird durch eingebrachtes Füllmaterial 40 aus Kohlenstoff optimiert;
- das gebildete Al₄C₃ ist wasserlöslich, so dass beschichtete Flächen, ohne mechanische Schädigung leicht gereinigt werden;
- Polymer (Binder) wirkt als reaktive Bindephase für das Metall bzw. die graphitischen Füllstoffe und erlaubt die Aufbringung der Diffusionsschicht in Form von Pasten und Lacken (Bindephase nimmt als reaktive Komponenten an dem Prozess teil), Abgrenzung zu stabilen Suspensionen mit keramischen Füllern mit Bindersystemen;
- vernetztes Polymer ist im "Grünzustand" mechanisch und chemisch bearbeitbar, d.h. es können bestimmte Stellen der Maskierung bei Bedarf von der späteren Beschichtung noch wieder abgetragen werden (z.B. Fenster herausgearbeitet werden);
- Schichtsystem ist bis 1200°C in inerten und reduzierenden Bedingungen stabil, eine Zersetzung oberhalb der Reaktionstemperatur von Al₄C₃ findet nicht statt (hohe Prozesssicherheit, keine nachfolgenden Reaktionen);
- hohe Variation in den Schichtdicken (effiziente Diffusionsbarriere);
- einfache Nachbearbeitung an kritischen Stellen, durch nachträgliche Pinselbeschichtung (Recyclingprozess vereinfacht);
- Variation des Füllmaterials 40 von Metall und Graphit erlaubt die gezielte Einstellung der thermischen Ausdehnungskoeffizienten von Basismaterial und Schutzsystem (rissfreie Beschichtungssysteme während des Refurbishments);
- Variation der Volumenanteile von Füllmaterial 40 und Polymer (Binder) erlauben poröse bis dichte Schichten von und Einstellung der Haftung und thermischen Anpassung.

Figur 7 zeigt in perspektivischer Ansicht eine Schaufel 120, 130, die sich entlang einer Längsachse 121 erstreckt.
Die Schaufel 120, 130 weist entlang der Längsachse 121 aufeinander folgend einen Befestigungsbereich 400, eine daran angrenzende Schaufelplattform 403 sowie einen Schaufelblattbereich 406 auf. Bei einer Innenbeschichtung ist der Schaufelblattbereich 406 durch eine Maskierung 7 geschützt.
Im Befestigungsbereich 400 ist ein Schaufelfuß 183 gebildet, der zur Befestigung der Laufschaufeln 120, 130 an der Welle dient. Der Schaufelfuß 183 ist als Hammerkopf ausgestaltet. Andere Ausgestaltungen, beispielsweise als Tannenbaum- oder Schwalbenschwanzfuß sind möglich. Bei herkömmlichen Schaufeln 120, 130 werden in allen Bereichen 400, 403, 406 der Laufschaufel 120, 130 massive metallische Werkstoffe verwendet.

Die Figur 8 zeigt eine Brennkammer 110 einer Gasturbine.
Die Brennkammer 110 ist beispielsweise als so genannte Ringbrennkammer ausgestaltet, bei der eine Vielzahl von in Umfangsrichtung um die Turbinenwelle 103 herum angeordneten Brennern 102 in einen gemeinsamen Brennkammerraum münden. Dazu ist die Brennkammer 110 in ihrer Gesamtheit als ringförmige Struktur ausgestaltet, die um die Turbinenwelle 103 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen. Jedes Hitzeschildelement 155 ist arbeitsmediumsseitig mit einer besonders hitzebeständigen Schutzschicht ausgestattet oder aus hochtemperaturbeständigem Material gefertigt. Aufgrund der hohen Temperaturen im Inneren der Brennkammer 110 ist zudem für die Hitzeschildelemente 155 bzw. für deren Halteelemente ein Kühlsystem vorgesehen.

Die Materialien der Brennkammerwand und deren Beschichtungen können ähnlich der Turbinenschaufeln 120, 130 sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

Die Figur 9 zeigt beispielhaft eine Gasturbine 100 in einem Längsteilschnitt.
Die Gasturbine 100 weist im Inneren einen um eine Rotationsachse 102 drehgelagerten Rotor 103 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.
Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.
Jede Turbinenstufe 112 ist aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind. An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt.
Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.
Um den dort herrschenden Temperaturen standzuhalten, werden diese mittels eines Kühlmittels gekühlt.
Ebenso können die Substrate eine gerichtete Struktur aufweisen, d.h. sie sind einkristallin (SX-Struktur) oder weisen nur längsgerichtete Körner auf (DS-Struktur).
Als Material werden eisen-, nickel- oder kobaltbasierte Superlegierungen verwendet.

Beispielsweise werden Superlegierungen verwendet, wie sie aus der EP 1 204 776, EP 1 306 454, EP 1 319 729, WO 99/67435 oder WO 00/44949 bekannt sind; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X steht für Yttrium (Y) und/oder Silizium (Si) und/oder zumindest ein Element der Seltenen Erden) und Wärme durch eine Wärmedämmschicht aufweisen.
Die Wärmedämmschicht besteht beispielsweise ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.
Bei der Beschichtung kann die erfindungsgemäße Maskierung verwendet werden.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Bei Beschichtungen von Bauteilen für die Gasturbine 100 (Fig. 8) oder die Brennkammer 110 (Fig. 8) wird die Maskierung 7 eingesetzt, um eine unerwünschte Beschichtung zu vermeiden.

## Patentansprüche

1. Verfahren zur Beschichtung einer Oberfläche (4) eines Bauteils (1, 120, 130, 153, 155),
insbesondere einer Turbinenschaufel (120, 130),
das zumindest folgende Schritte umfasst:
- Aufbringung einer Maskierung (7) auf bestimmte Bereiche (10) der Oberfläche (4, 406) des Bauteils (1, 120, 130, 153, 155),
die keine Beschichtung aufweisen sollen,
wobei die Maskierung (7) aus einer ersten Schicht (34), die auf der Oberfläche (4) aufliegt, und zumindest einer zweiten, äußersten Schicht (37), die auf der ersten Schicht (34) vorhanden ist, besteht,
- Beschichtung (13) des Bauteils (1, 120, 130, 153, 155),
**dadurch gekennzeichnet,**
**dass** die zweite, äußerste Schicht (37) kleinere Poren, insbesondere eine geringere Porosität, aufweist als die erste Schicht (34),
**dass** die erste Schicht (34) und die zweite Schicht (37) zumindest teilweise aus Pulver bestehen und unterschiedliche Korngrößenverteilungen aufweisen,
wobei das Material der ersten Schicht (34) und/oder der zweiten Schicht (37) und/oder das Füllmaterial (40) entweder zumindest teilweise aus Keramik und einem Kohlenstoff-Precursor oder
aus einem Kohlenstoff/Metallgemisch und einem Kohlenstoff-Precursor besteht.

2. Verfahren nach Anspruch 1,
**dadurch gekennzeichnet, dass**
dass die erste Schicht (34) und zweite Schicht (37) zumindest teilweise aus Pulver bestehen und
eine ähnliche Korngrößenverteilung aufweisen, und
dass die zweite, äußerste Schicht (37) durch Auffüllen mit Füllmaterial (40) gebildet wird.

3. Verfahren nach Anspruch 1,
**dadurch gekennzeichnet, dass**
dass die erste Schicht (34) und die zweite Schicht (37) zumindest teilweise aus Pulver bestehen, und
dass eine mittlere Korngrößenverteilung (d2) der zweiten äußersten Schicht (37) kleiner ist als die der ersten Schicht (34)

4. Verfahren nach einem oder mehreren der Ansprüche 1 bis 3,
**dadurch gekennzeichnet, dass**
die zweite Schicht (37) weniger gasdurchlässig als die erste Schicht (34) ausgebildet wird.

5. Verfahren nach einem oder mehreren der Ansprüche 1 bis 4,
**dadurch gekennzeichnet, dass**
das Material der ersten Schicht (34) und/oder der zweiten Schicht (37) und/oder das Füllmaterial (40) zumindest teilweise aus Kohlenstoff, insbesondere Graphit, und einem Kohlenstoff-Precursor besteht.

6. Verfahren nach einem oder mehreren der Ansprüche 1 bis 5,
**dadurch gekennzeichnet, dass**
die erste Schicht (34) und/oder die zweite Schicht (37) und/oder das Füllmaterial (40) einen Binder enthält, der den Kohlenstoff-Precursor bildet.

7. Verfahren nach Anspruch 6,
**dadurch gekennzeichnet, dass**
eine Wärmebehandlung mit der Maskierung (7) durchgeführt wird,
bevor die Beschichtung (13) erfolgt,
so dass der Binder in Kohlenstoff,
insbesondere mit Partikelgrößen im Nanometer-Bereich, umgewandelt wird.

8. Verfahren nach Anspruch 1,
**dadurch gekennzeichnet, dass**
das Material der Maskierung (7) mit einem Beschichtungsmaterial (19) der Beschichtung (13) zu einem leicht entfernbaren Reaktionsprodukt,
insbesondere wasserlöslichem, insbesondere karbidischem Reaktionsprodukt,
reagiert.

9. Verfahren nach einem oder mehreren der vorherigen Ansprüche,
**dadurch gekennzeichnet, dass**
das Verfahren mit neu hergestellten Bauteilen (1, 120, 130, 153, 155) oder mit wieder aufzuarbeitenden Bauteilen (1, 120, 130, 153, 155) durchgeführt wird,
insbesondere einer Dampf- oder Gasturbine (100).

10. Bauteil (1, 120, 130, 153, 155),
insbesondere für eine Gas- (100) oder Dampfturbine, insbesondere eine Turbinenschaufel (120, 130),
das zur Beschichtung (13) vorgesehen ist und eine Maskierung (7) auf bestimmten Bereichen (10) der Oberfläche (4, 406) des Bauteils (1, 120, 130, 153, 155) aufweist,
die keine Beschichtung aufweisen sollen,
wobei die Maskierung (7) aus einer ersten Schicht (34), die auf der Oberfläche (4) aufliegt,
und zumindest einer zweiten, äußersten Schicht (37), die auf der ersten Schicht (34) vorhanden ist,
besteht,
**dadurch gekennzeichnet,**
**dass** die zweite, äußerste Schicht (37) kleinere Poren, insbesondere eine geringere Porosität, aufweist als die erste Schicht (34),
**dass** die erste Schicht (34) und die zweite Schicht (37) zumindest teilweise aus Pulver bestehen und unterschiedliche Korngrößenverteilungen aufweisen,
wobei das Material der ersten Schicht (34) und/oder der zweiten Schicht (37) und/oder das Füllmaterial (40) entweder zumindest teilweise aus Keramik und einem Kohlenstoff-Precursor oder
aus einem Kohlenstoff/Metallgemisch und einem Kohlenstoff-Precursor besteht.

11. Bauteil nach Anspruch 10,
**dadurch gekennzeichnet, dass**
dass die erste Schicht (34) und zweite Schicht (37) zumindest teilweise aus Pulver bestehen und
eine ähnliche Korngrößenverteilung aufweisen, und
dass die zweite, äußerste Schicht (37) mit einem Füllmaterial (40) aufgefüllt ist.

12. Bauteil nach Anspruch 10,
**dadurch gekennzeichnet, dass**
dass die erste Schicht (34) und zweite Schicht (37) zumindest teilweise aus Pulver bestehen, und
dass eine mittlere Korngrößenverteilung (d2) der zweiten äußersten Schicht (37) kleiner ist als die der ersten Schicht (34).

13. Bauteil nach einem oder mehreren der vorherigen Ansprüche 10 bis 12,
**dadurch gekennzeichnet, dass**
die zweite Schicht (37) weniger gasdurchlässig als die erste Schicht (34) ausgebildet ist.

14. Bauteil nach einem oder mehreren der vorherigen Ansprüche 10 bis 13,
**dadurch gekennzeichnet, dass**
das Bauteilen (1, 120, 130, 153, 155) ein neu hergestelltes oder
ein wieder aufgearbeitetes Bauteil (1, 120, 130, 153, 155) ist.
